(19) Europäisches Patentamt
European Patent Office
Office européen des brevets

(11) EP 0 859 069 A1

(12) **EUROPEAN PATENT APPLICATION**
published in accordance with Art. 158(3) EPC

(43) Date of publication:
19.08.1998 Bulletin 1998/34

(51) Int. Cl.$^6$: **C23C 14/30**, C23C 14/56

(21) Application number: 97917452.1

(86) International application number:
PCT/JP97/01368

(22) Date of filing: 21.04.1997

(87) International publication number:
WO 97/40206 (30.10.1997 Gazette 1997/46)

(84) Designated Contracting States:
DE FR GB

(30) Priority: 22.04.1996 JP 124089/96

(71) Applicant:
TOYO METALLIZING CO.,LTD.
Tokyo 103 (JP)

(72) Inventors:
• TOHYAMA, Shunroku,
Toray Yoroizaka D-54
Mishima-shi, Shizuoka 411 (JP)

• AOYAGI, Tsutomu
Machida-shi, Tokyo 195 (JP)
• MOCHIZUKI, Kiyohito
Tagata-gun, Shizuoka 419-01 (JP)
• TANI, Satoru
Nagaizumi-cho, Sunto-gun, Shizuoka 411 (JP)

(74) Representative: Kador & Partner
Corneliusstrasse 15
80469 München (DE)

(54) **DEVICE AND METHOD FOR CONTINUOUS VAPOR-DEPOSITION ON FILM**

(57) This invention provides the best design regarding the number and positioning of the projecting points so as to attain the uniformity in the width direction and the optimum productivity using the plural EB guns/plural projecting points, therefor provides an appatatus and process for continuous vapor deposition to a film which enables a formation of thin layer having an improved uniformity and precision.

This invention relates to the apparatus satisfying the following faetures in an apparatus whereby a thin layer or plural number of thin layers composed of a dielectric substance or metal are continuously formed onto a running organic polymer film in the width range wider than 500mm, in the vapor deposition system that a vapor deposition substance is introduced to and kept in the hearth moving at a constant speed and continuously moved for a projecting point of electron beam,

(1) To have at least two projecting points of electron beam in the width direction of the film with respect to one kind of vapor deposition substance.
(2) The vertical distance between the projecting point of electron beam and the running surface of the film is not less than 300mm.
(3) Both moving direction and moving speed of the hearth can be set independently in each hearth.
(4) A compensator suitable for attaining an uniform vapor deposition speed in the width direction of the film is equipped between the projecting point of electron beam and the running surface of the film.

EP 0 859 069 A1

## Description

<u>Technical field</u>

The present invention relates to an appatatus for continuous vapor deposition to a film wherein thin layer or layers of a dielectric substance or metal are continuously and stably formed to a film composed of an organic polymer and a process using such an apparatus for continuous vapordeposition to a film wherein thin layer or layers of a dielectric substance or metal are continuously formed to a film having a long length and wide width composed of an organic polymer.

The present invention relates to an appatatus and process for continuous vapor deposition to a film which enable a formation of thin layer having a sufficient uniformity of thickness both in the length direction and the width direction to a long organic polymer film having a wide width, e. g. wider than 500mm.

<u>Background Art</u>

It has been well known that a thin layer of metal oxide is formed onto a long film having a wide width in order to impart various functions. For example, so as to impart a gas barrier property to a film , it has been practically used to form a thin layer of silicon dioxide onto a polyester film. In this case, a high uniformity and precision regarding thickness and structure is not required because the object is to impart a gas barrier property to a film.

It has been a conventional practice that in order to impart an anti-reflection ability to a film, one thin layer composing multiple layers of a dielectric substance such as silicon dioxide is formed. For example, Japanese patent application laid-open No. 56-113101 proposes a method wherein a thin layer having a thickness of about 1 micron of silicon oxide is formed onto a basic film by vacuum vapor deposition and then onto such a layer a multi-layer anti-reflection layer is formed by a coating method.

And Japanese publication No.6-85001 proposes an optical article which is obtained by forming a four-layer anti-reflection layer wherein the first and fourth are composed of silicon oxide to a trasparent plastic film after forming a bard coating layer. In this case, a high uniformity and precision regarding thickness seems to be important in light of the object , that is, to impart an anti-reflection ability.

But, in the case that a high uniformity and precision regarding thickness and structure is required , there is no prior art which shows a recognition about a difficulty of obtaining a high uniformity and precision as far as a continuous forming of a thin layer composed of metal oxide onto a long film is concerned. Therefor, there is no proposal regarding such a continuous process of improving an uniformity and precision.

<u>Disclosure of the invention</u>

The inventors were confronted with a difficulty when they have tried a continuous forming by electrone beam method of a thin layer composed of a dielectric substance represented by metal oxide such as silicon oxide or metal onto a long film wherein such a thin layer is one of a multi-layer.

Namely, in order to carry out a continuous forming of a thin layer onto a long film with a wide width, it is necessary to provide continuously the substance to be vaporized such as silicon oxide to the area projecting an electron beam in the same vacuum zone.

The inventors have found out following method . First, a vapor deposition substance is filled into a particular hearth always movable to same direction e.g. rotary hearth (herein the hearth means container that deposites or keeps a vapor deposition substance ). In the electron beam projecting area some of vapor deposition substance is vaporized and consumed. Next, a vapor deposition substance is additionally provided to the hearth in the amount corresponding to vaporizing and consuming. Last, the hearth comes back to the electron beam projecting area.

And, it has been an important matter to be solved that in order to form a thin layer of vapor deposition substance having a high uniformity in the width direction with some degree of productivity, plural number of elrectron beam and vaporizing point in the width direction is necessary and a design effective for getting a good balance of productivity and the above mentioned uniformity is necessary.

Generally speaking, when a vapor deposition substance is vaporized by projecting the electron beam to them, and the resulting vapor is deposited on base plate (in this invention , the base plate is a running film ) located in the vaporizing area. And, the rate of vapor deposition in a certain one point of base plate is determined depending on the distance and angle between its one point and vaporizing point.

In the case that the base plate is plane and plane plate is located horizontally to a certain point right over the vaporizing point, it is proved both experimentally and theoritically that the rate of vapor deposition in a certain one point of base plate is proportionary to $\cos^n \theta$ ($\theta$ means the angle of the projecting point and cartain point).

From this , in order to accompolish an uniform rate of vapor deposition with respect to surface of the base plate, the base plate has to be located along with the curved surface equal to the vapor density, that is , the curved surface along with $\cos^n \theta$. In this invention, the film has to be run in such a manner.

Further, it is almost impossible that one vapor deposition substance covers a wide area ( especially the wide area in the width direction) of the wide base plate, considering productivity.

In this invention, it is possible to control a thickness and its uniformity of a thin layer in the length direction by controlling a running speed of the film. Using an avaiable electron beam gun, one electron beam gun /one vapor deposition substance system is sufficient in the width less than 500mm by using a compensator effective for obtaining the thickness uniformity.

Namely the object of this invention is to provide an apparatus for continuous vapor deposition to a film , which enables an attainment of an improved uniformity and precision regarding a thickness and structure, in the apparatus whereby a thin layer or plural number of layers composed of a dielectric substance or metal are continuously formed onto a running organic polymer film in the width range wider than 500mm, preferably, wider than 1000mm, in the vapor deposition system that a vapor deposition substance is introduced to and kept in the hearth moving at the same speed and it is continuously moved for a projecting point of electron beam.

The another object of this invention is to provide the process using such an appparatus.

Stating in more detail, the object of the invention is to provide the most preferable design regarding the number and positioning of the vapor deposition substance so as to attain an uniformity of the thickness in the width direction and the highest productivity using plural electron beam guns/plural vaporizing point system, and thereby to provide an apparatus for continuous vapor deposition to a film which enables an attainment of an improved uniformity and precision regarding a thickness and structure, and to provide a process for continuous vapor deposition to a film using such an apparatus.

After the inventor's eager study, the object of the invention has been advantageously achieved in the industrial practice by this invention having the following features.

[1] In an apparatus whereby a thin layer or plural number of thin layers composed of a dielectric substance or metal are continuously formed onto a running organic polymer film in the width range wider than 500mm, in the vapor deposition system that a vapor deposition substance is introduced to and kept in the hearth moving at a constant speed and continuously moved for a projecting point of electron beam, the apparatus satisfying the following faetures,

(1)To have at least two projecting points of electron beam in the width direction of the film with respect to one kind of vapor deposition substance.
(2)The vertical distance between the projecting point of electron beam and the running surface of the film is not less than 300mm.
(3)Both moving direction and moving speed of the hearth can be set independently in each hearth.

(4)A compensator suitable for attaining an uniform vapor deposition speed in the width direction of the film is equipped between the projecting point of electron beam and the running surface of the film.

[2]The appsaratus according to thr above -mentioned [1] , which is characterized in that a number of the projecting point is 2m(m means an integral number not less than 1) , and each m number of projecting point is symmetrically arranged in the both sides of the point A positioned within ±200mm from the center in the width direction of the film, and the distance between the projecting points of electron beam located at the ends in the width direction of the film and point A is within the range represented by the following equation.

$$(m-1)\, L/\,(m+1) \leqq X \leqq m\, L/(m+1)$$

[3]The appsaratus according to thr above -mentioned [1] , which is characterized in that a number of the projecting point is 2m+1(m means an integral number not less than 1) , and one projecting point is arranged at the point A positioned within ±200mm from the center in the width direction of the film, and the residual 2m number of projecting points are arranged symtrically arranged in the both sides of the point A , divided into each m munber and the distance between the projecting points of electron beam located at the ends in the width direction of the film and point A is within the range represented by the following equation.

$$mL/(2m+1) \leqq X \leqq (m+1)L/(2m+1)$$

[4]The appsaratus according to thr above -mentioned [1] , which is characterized in that the hearth is rotatable in a circular motion and the figure of horizontal section of the container of vapor deposition substance is a torus obtained by removing the center portion of the disk.
[5]The process for continuous vapor deposition to a film wherein thin layer or layers of a dielectric substance or metal are continuously formed to the running film composed of an organic polymer in the width range of not less than 500mm which is characterized in that the vapor deposition substance is molded in the shape so that can be matched with the interior portion of the container and the apparatus according to thr above -mentioned [4] is used.
[6]The process for continuous vapor deposition to a film wherein thin layer or layers of a dielectric substance or metal are continuously formed to the running film composed of an organic polymer in the width range of not less than 500mm which is characterized in that the vapor deposition substance is charged to the hearth continuously or intermittently in the granular or powder and the apparatus according to thr above -mentioned [4] is used.

[7]The process according to the above -mentioned [6] , which is characterized in that the amount of charging the vapor deposition substance is coresponding to that vaporized and consumed.

A brief explanation of the drawing

Figure 1 is the model drawing for carrying out the example of the invention which shows the arrangement of the film and plural projecting points of the electron beam , the hearth keeping the vapor deposition substance, and the direction of rotation of the hearth and etc..

Figure 2 is the graph which shows the distribution of the thickness regarding the thin layer of the silicon dioxide in the width direction when the thin layer of the silicon dioxide is formed on the film F by using the hearth H 3 and EB gun corresponding to this hearth.

Figure 3 is the graph which shows the distribution of the total amount of vapor ization in the vaporizing point(EB projecting point)E1, E2, E3, E4, E5 in the example of the invention.

The symbols ( F, F0, H1~ H5, E1~E5)used in the drawing mean the following.

F: Polyeheneterephtarate film
F0:The center in the width direction of polyeheneterephtarate film F
H1, H2, H3, H4, H5:Five hearths
E1, E2, E3, E4, E5:Vaporizing point(EB projecting point)

Best mode for carrying out the invention

The each feature of the present invention is explained in detail in the following.

As the organic polymer film in the present invention, there is used the film suitable for forming one or plural thin layers of the vapor deposition substance thereon which have and reveal the targeted funtion.

For example, in the case that the target is to impart the anti-reflection funtion , there is used the film which has a transparency to transmit visibe light, for example the films formed of polyolefin-based resin, polymetharylic-based resin, polyester-based resin, polycarbonate-based resin, triacetate-based resin. The film may be one having thereon a hard coat layer. In the present invention, the film covers the sheet.

As the object of the present invention is to provide an apparatus and process for continuous vapor deposition to a film wherein thin layer or layers of a dielectric substance or metal are continuously and stably formed onto an organic polymer film having a long length and wide width composed of an organic polymer, in the present invention there is used the organic polymer film having the width not less than 500mm and the length not less than fifty meters, preferably, not less than five hundred meters.

If the product according to the present invention is to be attached to a display, it is the normal practice to form an anti-reflection film on one side surface of the product and place the opposite side surface in close contact with a display for use. Therefor, it is desirable to perform a chemical or physical surface treatment (coating, corona discharge treatment, or the like) in order to improve the adhesion between the jointing surfaces.

In the present invention, the metal oxide such as a silicon dioxide which is metallized on the surface of the film is filled to hearth in any shape of granular , powder ,and the molded article meeting the shape of the hearth from the molten state.

But in order to keep a constant vaporization , it is necessary in one time operation of metallizing that the vapor deposition substance to be filled have to be uniform in both shape and chemical composition.

When the granular or powder is used, it is desirable to add additionally it in the amount corresponding to the amount consumed continuously or intermittently because it has a low density. When the vapor deposition substance is used in the state of a molded article, it is desirable that it has the scale meeting one time operation of metallizing, because it has a high density.

When the vapor deposition substance is used in the state of a molded article, the electron beam is likely to be reflected on the surface.

Therefor, in order to improve the absorption ability of electron beam energy, it is desirable that the metallizing operation is started after the molded article is subjected to matting treatment of the surface or is coated with a thin layer of the granular or powder.

And it is necessary that the hearth should be electrically grounded to prevent the charging-up of the electron charge. But, the hearth should be completely isolated from the earth so as to prevent a short circuit from the plasma to the hearth or vapor deposition substance when the conductive substance such as ITO(a mixture of $In_2O_3$ and $SnO_2$)is used as the metal oxide and a high-frequency plasma treatment is carrried out as an assistant means.

Next, there is explained in the following the arrangement of at least 2 of electron beams which constitute a main feature of the present invention.

The plural number of the vapor deposition substance / vaporizing point (EB projecting point) is necessary for attaining a high productivity, when the film is metallized in the width not less than 500mm. In order to metallize the film in as large width as possible using one projecting point, the perpendicular distance D from the film to the projecting point should be more longer. But the metallizing speed is inversely proportional to a square of the distance D. And when the distance D is short, there takes place the unfavourable effect of radient heat from EB gun because the organic polymer film has not so high resistance against heat.

From these, the distance D should be not less than 300mm, preferably, not less than 500mm and a plural number of the projecting point is essential.

Considering that there is the limit in space regarding the vacuum apparatus and it is futile to arrange the projecting point largely beyond the metallinzing width, there is an upper limit regarding the number of the projecting point. In standarizing, it is a normal practice to arrange one projecting point per 250~450mm of the metallizing width.

Thinking about the certain one point of the film , the metallizing speed at that point is determined by counting all the deposited vapor at that point from all the vapor deposition substances.

It becomes a problem how the plural projecting points in the width direction are arranged in order to make the summing-up of the distribution of vapor even in all the metallizing portion in the width direction. At this case, it is impossible to make the summing-up of the plural distribution of vapor even regarding the width direction of the film, therefor the compensator needs so as to adjust and control the unevenness of the summing-up of the distribution of vapor , considering a permissible range. It is a problem to be solved in the plural arrangement of projecting point that the portion where the metallizing can not be done should be render as smallest as possible.

It is not always necessary to make the vaporizing amount same about all the vaporizing points. Usualy, the total balance of the distribution is optimized by the arrangement of the vapor deposition substance and the control of the vaporizing amount in each projecting point.

In order to form a thin layer onto a continuous and long film , a sufficient amount of the vapor deposition substance must be introduced.

It is difficult to introduce a sufficient amount of the vapor deposition substance at a determined position so that a stable metallizing can be obtained. Therefor, it is desirable that there is employed the way that the vapor deposition substance is filled to the the hearth moving at a constant speed or the rotating container and vapor deposition substance is moved for the projecting point, and therefor the necessary amount of the vapor deposition substance for a continuous and long film can be introduced only one time. And it is desirable to employ the way that the granular and powder of the vapor deposition substance is additionally introduced at the point far remote from the EB projecting point in the amount corresponding to comsuption.

When one time of introduction of the vapor deposition substance is employed, it is desirable that the vapor deposition substance is the molded article having such a figure as it can be set completely matching with the moving container, the molded article being one molded from the molten state and cooled. For this purpose, the rotating hearth with a figure of a torus in its horizontal section is advantageously employed.

Because the distribution of vaporization fluctualates depending upon the moving direction of the vapor deposition substance , it is necessary that the moving direction and moving speed of the plural hearths corresponding to the plural projecting points can be independently set each other so as to make the distribution of the summing-up of vaporization in the width direction even.

Paying an attention to one certain vaporizing point , the distribution of vaporization depends upon the moving direction of the vapor deposition substance, and therefor it is not symmetrical based on the projecting point. And, the summing-up of the plural vapors is not symmetrical against the center point of the plural projecting points. Accordingly, the center point of the film and the center point of the plural projecting points should be different. Namely, based upon the confirmation regarding the distribution of vaporization corresponding to the vaporization conditions in the particular projecting point by a necessary experiment and culculation, the positioning of the center point of the plural vaporizing points and the center point of the metallizing portion of the film in the width direction should be determined. After various studies, it has been found out that if the center of the plural projecting points is located within the range falling ± 200mm from the center of the metallizing portion of the film in the width direction, it become possible for the determined number of vapor deposition substance to take a good arrangement effective for uniform distribution. At the same time, it hs been also found out that the positioning of the projecting points located on the both ends of the film in the width direction is important. If the projecting points located on the both ends of the film in the width direction is positioned too inside, the metallizing speed in the end portion of the film in the the width direction is getting too low, and therefor an uniform metallizing in the width direction becomes impossible.

It has been found out that it is necessary for the projecting points located at the ends of the film in the width direction to be arranged near the ends of the metallizing portion or to be arranged beyond the metallizing portion in the width direction.

Namely, in the case that a number of the projecting point is 2m (m means an integral number not less than 1) , it is desirable that each m number of projecting points is symmetrically arranged in the both sides of the point A positioned within ±200mm from the center in the width direction of the film, and the distance between the projecting points of electron beam located at the ends in the width direction of the film and point A is within the range represented by the following equation.

$$(m-1) \, L/(m+1) \leqq X \leqq m \, L/(m+1) \qquad (1)$$

And in the case that a number of the projecting point is 2m+1(m means an integral number not less than 1) , it is desirable that one projecting point is arranged at the point A positioned within ±200mm from the center in the width direction of the film, and the residual 2m number of projecting points are arranged symmetrically arranged in the both sides of the point A , divided into each m munber and the distance between the projecting points of electron beam located at the ends in the width direction of the film and point A is within the range represented by the following equation.

$$mL/(2m+1) \leqq X \leqq (m+1)L/(2m+1) \qquad (2)$$

It is not desirable that X is too large , that is, the projecting point is positioned far beyond the ends of the metallizing portion, even if such an arrangement is effective for attaining the higher uniformity, because the not negligible amount of the vapor deposition substance comes to nothing. In practice, the range represented by the equation 1&2.

The arrangement design of residual projecting points can be determined by a simple trial culculation after the positioning of the projecting points at the end portion of the film is determined based upon the above equations. The arrangement of the projecting points is not always necessary to be symmetrical in right and left direction. By starting from the consideration on the symmetrical case and by compensating a particular unevenness of the distribution of the vaporization based upon the particular projecting point, and therefor, by minimizing the unevenness of the distribution of the summing-up of the vapor, the final and preferable arrangement design is possible.

To have an optimum arrangement design , it is necessary to use a suitable compensator in order to remove the residual unevenness , if any, of the distribution of summing -up of the vapor in the width direction.

It is natunal that the technology of EB method according to the present invention which can attain the formation of the metallized thin layer composed of metal oxide onto a long film can be applied for metallizing method using a various kind of substances. It is apparent from the above mentioned explanation that the present invention is advantageous for a formation of metallized layer composed of the metal oxide having a high viscosity in a molten state , for example silicon dioxide, aluminum oxide, secium oxide, tin oxide, antimon oxide, and lead oxide with a high uniformity of thickness.

Furthermore, it is apparent that the present invention which relates to the metallized layer of the metal or the metal oxide , that is, a dielectric substance, an electric conductor is advantageous for formation of not only a thin layer but also plural thin layers onto the film .

The plural thin layers onto the film include an anti-reflection thin layer.

In the present invention, the assistant measures such as high-frequency plasma, ion beam, plasma gun can be used. These measures are usualy employed and are advantageous for EB metallizing of the metal oxide and forming a sufficient and minute layer of the metal oxide that has a high degre of oxidization.

## Example

The embodiment of the present invention is explaind hereinafter.

The present invention is not limited by this example.

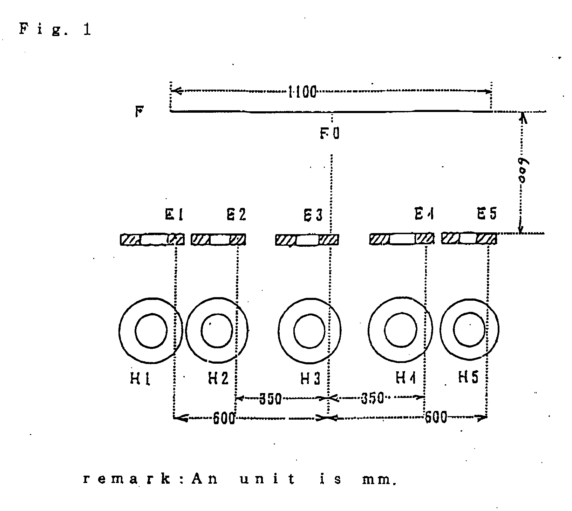

Figure 1 is a model drawing which shows the total relation of arrangement of the running film and the projecting points of five rotary hearths.

The example was carried out under such an arrangement.

The figures showing the peripherical section and section seen from the overhead regarding the rotary hearth are accompanied.

On one side surface of the polyethylenterephthalate film having a thickness of 150μm , width of 1100mm, length of 500m a hard coat layer is applied . That hard coat layer is mainly composed of the ultraviolet light curing type of polyfunctional acrylate resin and have a thickness of 6 μm.

On one side surface of this film the anti-reflection four layers were formed. The first to fourth layers are composed of the following.

First:zirconium oxide , Second:silicon dioxide , Third:titan oxide, Forth:silicon dioxide.

These metallizing materials were molded to form a disk having a thickness of 15mm, an outside diameter of tolus of 160mm and an inside diameter of tolus of 90mm so that they can be matched with the shape of the interior of the rotary hearth.

As shown in Fig. 1, five hearths (from right , H1, H2, H3, H4, H5) are arranged in the same level and on one horizontal line.

The arrangement relationship of the the surface of the running film and the hearths was determined so that the perpendicular distance between the the surface of the running film and the projecting points (from right E1, E2, E3, E4, E5) of the hearth. And the positioning of each hearth and each EB gun (not shown in the figure) is determined so that E1 and E5 are symmetrical and E2 and E4 are symmetrical against the center E3.

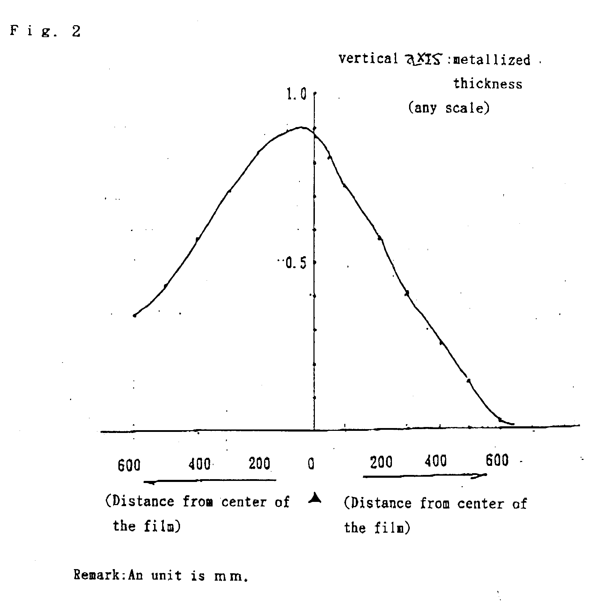

Figure 2 shows the measured result in the preliminary experiment about the distribution of the thickness regarding thin silicon oxide layer in the width direction when the silicon dioxide is metallized onto the film F using only hearth H3 and the corresponding EB gun in the specified metallizing condition ( the speed of rotation of the hearth, projecting condition of EB, the running speed etc.).

At this time, the rotation direction of the hearth H is counterclockwise in the same manner as in figure 1.

Apparent from Figure 2 , the distribution of the thickness of the thin layer is not symmetrical against the point F0 of the film just over the projecting point E3. As already explained, this is a deviation stemed from the rotation direction of the hearth, rotary speed of the hearth, and projecting condition.

This deviation can be estimated by a necessary culculation to the some degree.

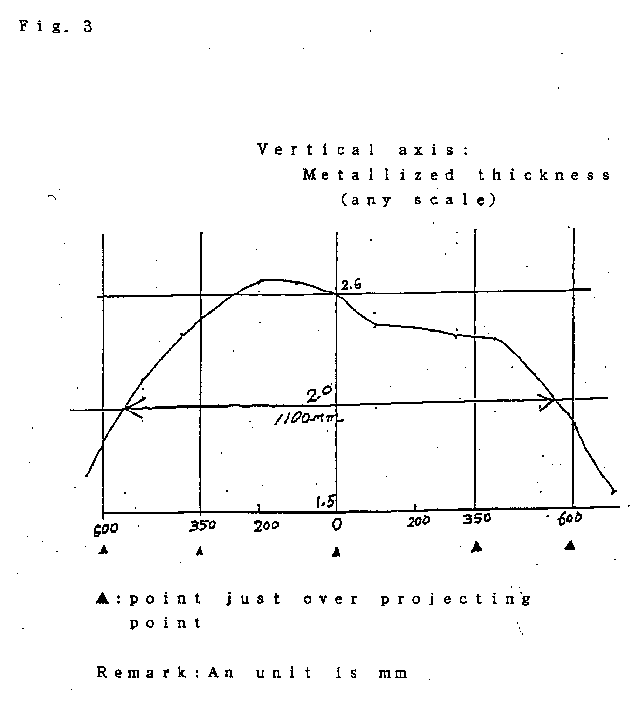

In practice, after the deviation is measured by the experiment, the positioning of the projecting points E1 E2 E3 E4 E5 and the hearth H1 H2 H3 H4 H5 and the rotation direction are determined. If the distribution shown in the figure 2 is given, the optimization of the thickness distribution on all the film surface can be attained by a trial culculation or computor simulation. In this case, each projecting point E1 E2 E4 E5 is far by 600mm, 350mm, 350mm, 600mm from the projecting point E3 as shown in the figure 1, and by this positioning the distribution of the summing-up of the vapor from the projecting points E1 E2 E3 E4 E5 can be obtained as shown in the figure 3.

As for the rotation direction of each hearth, it is preferable that it is clockwise for H1 H2 H4 and it is counterclockwise for H3 H5 by culculation.

Next, from the distribution of the summing-up of the vapor from the five projecting points which is obtained by the figure 1, a suitable shape of the compensator was determined for obtaining the metallized thin layer having 1100mm of width and 500m of length with a sufficient uniformity.

Based upon the forgoings, the positioning of the five projecting points and the rotation direction of the the hearth and the shape of the compensator were determined for the metallizing width of 1100mm. The second layer and forth layer composed of silicon dioxide were formed under such an arrangement of the five projecting points in the same condition as in the preliminary experiment of the figure 2.

As for the first layer composed of zirconium oxide and the third layer composed of titan oxide, after carrying out the same preliminary experiment as the above-mentioned one, the positioning of the five projecting points and the rotation direction of the the hearth and the shape of the compensator were determined. Thus, the anti-reflection four layers were obtained.

The resulting anti-reflection layers have 500m length and 1100mm width and have a reflection ratio of not more than 1.0 % in the visible ray range of the wavelength 450~650 nm. And the resulting anti-reflection layers are extremely superior in uniformity.

In this example the center position (E3) of the five projecting points can be in comformity with the center of the film in the width direction.

But, when the distribution of the vapor from only one E3 is not so symmetrical, the center position of the plural projecting points should be deviated from the center of the film in the width direction.

At the same time, the relationship in arrangement of the plural projecting points with each other should be one deviated from the symmetrical arrangement as shown in this example.

Indutrial applicability

According to the present invention, thin layer or layers of a dielectric substance or metal can be continuously and stably formed onto the film composed of an organic polymer having a long length and wide width by the metallizing method using the plural EB guns, and the product having a high quality uniformity with length direction and width direction can be obtained.

The apparatus and process according to the present invention are particularly advantageous for an industrial production of a plastic optical product having a multi-antireflection layer.

Therefor, the optical article may be effectively applied to a cathod ray tube, a liquid crystal display, and a glass or plastic showcase.

## Claims

1. In an apparatus whereby a thin layer or plural number of thin layers composed of a dielectric substance or metal are continuously formed onto a running organic polymer film in the width range wider than 500mm, in the vapor deposition system that a vapor deposition substance is introduced to and kept in the hearth moving at a constant speed and continuously moved for a projecting point of electron beam, the apparatus satisfying the following faetures,

   (1)To have at least two projecting points of electron beam in the width direction of the film with respect to one kind of vapor deposition substance.
   (2)The vertical distance between the projecting point of electron beam and the running surface of the film is not less than 300mm.
   (3)Both moving direction and moving speed of the hearth can be set independently in each hearth.
   (4)A compensator suitable for attaining an uniform vapor deposition speed in the width direction of the film is equipped between the projecting point of electron beam and the running surface of the film.

2. The apparatus according to claim 1, which is characterized in that a number of the projecting point is 2m(m means an integral number not less than 1), and each m number of projecting points is symmetrically arranged in the both sides of the point A positioned within ±200mm from the center in the width direction of the film, and the distance between the projecting points of electron beam located at the ends in the width direction of the film and point A is within the range represented by the following equation.

$(m-1) L/ (m+1) \leqq X \leqq m L/(m+1)$

3. The apparatus according to claim 1 , which is characterized in that a number of the projecting point is $2m+1$ ($m$ means an integral number not less than 1) , and one projecting point is arranged at the point A positioned within $\pm200mm$ from the center in the width direction of the film, and the residual $2m$ number of projecting points are arranged symmetrically arranged in the both sides of the point A , divided into each $m$ number and the distance between the projecting points of electron beam located at the ends in the width direction of the film and point A is within the range represented by the following equation.

$$mL/(2m+1) \leqq X \leqq (m+1)L/(2m+1)$$

4. The apparatus according to claim 1 , which is characterized in that the hearth is rotatable in a circular motion and the figure of horizontal section of the container of vapor deposition substance is a torus obtained by removing the center portion of the disk.

5. The process for continuous vapor deposition to a film wherein thin layer or layers of a dielectric substance or metal are continuously formed to the running film composed of an organic polymer in the width range of not less than 500mm which is characterized in that the vapor deposition substance is molded in the shape so that can be matched with the interior portion of the container and the apparatus according to claim 4 is used.

6. The process for continuous vapor deposition to a film wherein thin layer or layers of a dielectric substance or metal are continuously formed to the running film composed of an organic polymer in the width range of not less than 500mm , which is characterized in that the vapor deposition substance in the state of the granular or powder is charged to the hearth continuously or intermittently in the amount corresponding to that vaporized and consumed and the apparatus defined in claim 4 is used.

Fig. 1

remark:An unit is mm.

F i g. 2

vertical axis :metallized
thickness
(any scale)

1.0

0.5

600    400    200    0    200    400    600

(Distance from center of    ▲    (Distance from center of
the film)                          the film)

Remark:An unit is mm.

Fig. 3

Vertical axis:
Metallized thickness
(any scale)

▲:point just over projecting
point

Remark:An unit is mm

## INTERNATIONAL SEARCH REPORT

| | International application No. |
|---|---|
| | PCT/JP97/01368 |

**A.   CLASSIFICATION OF SUBJECT MATTER**

Int. Cl$^6$  C23C14/30, 14/56

According to International Patent Classification (IPC) or to both national classification and IPC

**B.    FIELDS SEARCHED**

Minimum documentation searched (classification system followed by classification symbols)

Int. Cl$^6$  C23C14/30, 14/56

Documentation searched other than minimum documentation to the extent that such documents are included in the fields searched

| | | |
|---|---|---|
| Jitsuyo Shinan Koho | 1926 - 1996 | Jitsuyo Shinan Toroku |
| Kokai Jitsuyo Shinan Koho | 1971 - 1997 | Koho    1996 - 1997 |
| Toroku Jitsuyo Shinan Koho | 1994 - 1997 | |

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
|---|---|---|
| A | JP, 61-94239, A (Fuji Photo Film Co., Ltd.), May 13, 1986 (13. 05. 86)(Family: none) | 1 - 6 |

☐  Further documents are listed in the continuation of Box C.          ☐  See patent family annex.

| | |
|---|---|
| *    Special categories of cited documents: | "T"  later document published after the international filing date or priority date and not in conflict with the application but cited to understand the principle or theory underlying the invention |
| "A"  document defining the general state of the art which is not considered to be of particular relevance | |
| "E"  earlier document but published on or after the international filing date | "X"  document of particular relevance; the claimed invention cannot be considered novel or cannot be considered to involve an inventive step when the document is taken alone |
| "L"  document which may throw doubts on priority claim(s) or which is cited to establish the publication date of another citation or other special reason (as specified) | |
| "O"  document referring to an oral disclosure, use, exhibition or other means | "Y"  document of particular relevance; the claimed invention cannot be considered to involve an inventive step when the document is combined with one or more other such documents, such combination being obvious to a person skilled in the art |
| "P"  document published prior to the international filing date but later than the priority date claimed | "&"  document member of the same patent family |

| Date of the actual completion of the international search | Date of mailing of the international search report |
|---|---|
| July, 8, 1997 (08. 07. 97) | July 23, 1997 (23. 07. 97) |

| Name and mailing address of the ISA/ | Authorized officer |
|---|---|
| Japanese Patent Office | |
| Facsimile No. | Telephone No. |

Form PCT/ISA/210 (second sheet) (July 1992)